# EUROPÄISCHE PATENTSCHRIFT

(11) **EP 2 232 455 B1**
(45) Veröffentlichungstag und Bekanntmachung des Hinweises auf die Patenterteilung: **24.04.2013**
(21) Anmeldenummer: 09700171.3
(22) Anmeldetag: 07.01.2009
(51) Int. Cl.: G08B 25/06, G08B 29/06, G08B 29/08, G01R 31/02

(54) **ÜBERWACHUNGSVORRICHTUNG FÜR EIN MELDESYSTEM, MELDESYSTEM UND VERFAHREN ZUR ÜBERWACHUNG DES MELDESYSTEMS**
MONITORING DEVICE FOR AN ALARM SYSTEM, ALARM SYSTEM, AND METHOD FOR MONITORING SAID ALARM SYSTEM
DISPOSITIF DE CONTRÔLE POUR UN SYSTÈME D'ALARME, SYSTÈME D'ALARME ET PROCÉDÉ DE CONTRÔLE DU SYSTÈME D'ALARME

(30) Priorität: 10.01.2008 DE 102008003799
(43) Veröffentlichungstag der Anmeldung: 29.09.2010
(73) Patentinhaber: Robert Bosch GmbH, 70442 Stuttgart (DE)
(72) Erfinder: GUERTNER, Michael, 80798 Muenchen (DE); SCHMIDL, Joachim, 80935 Muenchen (DE); PREISINGER, Marcus, 82008 Unterhaching (DE)
(86) Internationale Anmeldenummer: PCT/EP2009/050125
(87) Internationale Veröffentlichungsnummer: WO 2009/087169

(56) Entgegenhaltungen:
- EP-A- 1 197 936
- WO-A-79/00844

## Beschreibung

### Stand der Technik

Die Erfindung betrifft eine Überwachungsvorrichtung zur Überwachung des Betriebszustands von Versorgungs- und/oder Signalleitungen eines Meldesystems, insbesondere eines Brandschutz- und/oder Gefahrenmeldesystems, mit einer Messeinrichtung, welche zur Erzeugung eines Messsignals in Abhängigkeit des Betriebszustands in den Versorgungs- und/oder Signalleitungen ausgebildet, verschaltet und/oder verschaltbar ist, und mit einer Auswerteeinrichtung, welche ausgebildet ist, das Messsignal auszuwerten und auf Basis der Auswertung ein Überwachungssignal auszugeben. Die Erfindung betrifft weiter ein Meldesystem mit dieser Überwachungsvorrichtung sowie ein Verfahren zur Überwachung eines oder des Meldesystems.

Meldesysteme, wie zum Brandschutz- und/oder Gefahrenmeldesysteme, werden vielfach in öffentlichen oder gewerblichen Einrichtungen eingesetzt und dienen zum einen dazu, Benutzern die Möglichkeit zu geben, einen Hilferuf oder einen Notruf auszulösen, und zum anderen, über geeignete Signalisierungseinrichtungen, wie z. B. Sirenen, Notbeleuchtungen, etc., eine Hilfs- oder Notfallsituation zu visualisieren bzw. durch Tonausgabe anzuzeigen.

Nachdem derartige Meldesysteme nur sehr selten - im Idealfall nie - betätigt werden, stellt es eine Herausforderung dar, den korrekten Betriebszustand des Meldesystems ständig und insbesondere ohne Beeinträchtigung des normalen Tagesablaufs im Bereich des Meldesystems sicherzustellen. Natürlich wäre es möglich, in regelmäßigen Abständen das Meldesystem durch Probeaktivierung zu überprüfen, jedoch müssen die sich im Bereich des Meldesystems befindlichen Personen bei jeder Überprüfung entsprechend vorbereitet werden.

Die Druckschrift DE 195 38 754 C2, die wohl den nächstkommenden Stand der Technik bildet, betrifft ein Verfahren zur Überwachung von Primärleitungen eines Meldesystems, wobei zur Detektion von Zustandsänderungen der Leitungen die Primärleitung einen Meldewiderstand und einen Referenzwiderstand aufweist, die in Serie geschaltet sind. Mögliche Fehlfunktionen der Primärleitung werden durch Auswertung des Quotienten aus dem Spannungsabfall am Referenzwiderstand und dem Spannungsabfall an dem Meldewiderstand ermittelt.

EP 1197936 offenbart eine Gefahrenmeldeanlage mit einer Vielzahl von Meldern.

### Offenbarung der Erfindung

Erfindungsgemäß wird eine Überwachungsvorrichtung mit den Merkmalen des Anspruchs 1, ein Meldesystem mit den Merkmalen des Anspruchs 10 sowie Verfahren mit den Merkmalen der Ansprüche 14 und 15 vorgeschlagen. Bevorzugte oder vorteilhafte Ausführungsformen der Erfindung ergeben sich aus den Unteransprüchen, der nachfolgenden Beschreibung und den beigefügten Figuren.

Die erfindungsgemäße Überwachungsvorrichtung ist bevorzugt als ein Modul ausgebildet, welches zur Integration in einem Meldesystem geeignet und/oder ausgebildet ist, wobei die Überwachungsvorrichtung insbesondere stationär und/oder dauerhaft in dem Meldesystem integriert ist. Die Überwachungsvorrichtung dient zur Überwachung des Betriebszustands von Versorgungs- und/oder Signalanleitungen des Meldesystems.

Bei einem möglichen Anwendungsfall, z.B. bei sogenannten Zweidrahtsystemen, werden die Versorgungs- und Signalleitungen durch genau zwei Leitungen dargestellt, die dann durch die Überwachungsvorrichtung überwacht werden. Bei einem anderen Anwendungsfall, z.B. bei den sogenannten Vierdrahtsystemen, sind die Versorgungs- bzw. die Signalleitungen jeweils als separate Zweidrahtsysteme ausgebildet und verlaufen unabhängig voneinander, wobei wahlweise nur die Versorgungsleitungen oder nur die Signalleitungen mit einer derartigen Überwachungsvorrichtung überwacht werden.

Bei einer besonders bevorzugten Umsetzung sind die Versorgungsleitungen zur Energieversorgung von Signalisierungseinrichtungen oder Signalausgabeeinrichtungen, z.B. Sirenen und/oder Vorrichtungen zum Personenschutz bei Brandmeldeanlagen, ausgebildet. Bei dieser Umsetzung werden die Versorgungsleitungen aufgrund des erhöhten Energiebedarfs der Signalisierungseinrichtungen mit einer separaten, von der eigentlichen Steuer- und/oder Signalleitung getrennten Energieversorgung betrieben. Dabei ist die Überwachungsvorrichtung zur Überwachung der Versorgungsleitungen von der Energieversorgung zu den Signalisierungseinrichtungen ausgebildet und/oder angeordnet und/oder verschaltet.

Die Überwachungsvorrichtung weist eine Messeinrichtung auf, welche zur Erzeugung eines Messsignals in Abhängigkeit des Betriebszustands, insbesondere in Abhängigkeit der Betriebsspannung, in den Versorgungs- und/oder Signalleitungen ausgebildet, verschaltet und/oder verschaltbar ist.

Ferner umfasst die Überwachungsvorrichtung eine Auswerteeinrichtung, um das durch die Messeinrichtung erzeugte Messsignal auszuwerten und auf Basis der Auswertung ein Überwachungssignal auszugeben. Das Überwachungssignal beschreibt den Zustand bzw. Betriebszustand der überwachten Versorgungs - und/oder Signalleitung.

Im Rahmen der Erfindung wird vorgeschlagen, in der Überwachungsvorrichtung eine steuerbare Signalquelle zu integrieren, welche zur Einkopplung eines Prüfsignals in die Versorgungs- und/oder Signalleitung ausgebildet, verschaltet und/oder verschaltbar ist, wobei das Messsignal die Systemantwort der Versorgungs- und/oder Signalleitungen auf das Prüfsignal umfasst. Bevorzugt ist die Signalquelle als eine Energiequelle, welche elektrische Energie in die Versorgungs- und/oder Signalleitungen eingespeist, oder als Verbraucher, welche der Versorgungs- und/oder Signalleitung einen vorgegebenen Prüfstrom entnimmt, ausgebildet.

Es ist eine Überlegung der Erfindung, eine Überwachungsvorrichtung zum Erkennen von Veränderungen in Leitungen vorzuschlagen, welche eine Erkennung erlaubt, bevor die Veränderungen zu Fehlfunktionen führen. Als Bezeichnungen für mögliche Zustandsänderungen der Leitungen wurden die aus dem angelsächsischen Sprachraum bekannten Begriffe "Creeping-short" und "Creeping-open" in der deutschen Sprache als "schleichender Kurzschluss" und "schleichende Unterbrechung" eingeführt. In der Fachwelt versteht man unter dem Begriff des schleichenden Kurzschlusses eine langsam fortschreitende Verkleinerung des Widerstands zwischen zwei Adern, zum Beispiel von Zweidrahtleitungen, unter schleichende Unterbrechung eine langsam fortschreitende Vergrößerung des Leitungswiderstands von einer, zweier oder mehr Adern, zum Beispiel der Zweidrahtleitung. Als Ursache für diese langsamen Veränderungen können Umwelteinflüsse ermittelt werden, vorwiegend Feuchtigkeit und Gase, die zur Oxidation von Kontaktstellen der Kupferdrähte oder zur Verringerung der isolierenden Eigenschaften zwischen den Kupferleitungen führen. Durch die Einkopplung des Prüfsignals in die Versorgungs- und/oder Signalleitungen und die Auswertung der Systemantwort, also der Reaktion der Versorgungs- und/oder Signalleitungen auf das Prüfsignal, kann auf den aktuellen Zustand der Leitungen geschlossen werden.

Bei einer möglichen Weiterbildung der Erfindung ist das Prüfsignal als ein Wechselspannungssignal bzw. als ein Wechselstromsignal ausgebildet, so dass die dynamische Systemantwort der Versorgungs- und/oder Signalleitungen ausgewertet werden kann.

Bei einer bevorzugten Ausführungsform der Erfindung ist das Prüfsignal jedoch als ein Gleichspannungssignal und/oder ein Gleichstromsignal ausgebildet, welches sich langsam, insbesondere langsamer als die üblichen Schaltzeiten der Signalisierungseinrichtungen des Meldesystems, ändert. Bei dieser Ausführungsform kann das Prüfsignal beispielsweise als ein Treppensignal oder ein Konstantsignal ausgebildet sein.

Es ist dabei insbesondere bevorzugt, dass die Auswerteeinrichtung zur Auswertung der Systemantwort der Versorgungs- und/oder Signalleitungen in dem Messsignal auf einen Gleichspannungsanteil in dem Prüfsignal ausgebildet ist. Beispielsweise wäre es möglich, Tiefpassfilter vor die Auswerteeinrichtung zu setzen, ohne den relevanten Informationsgehalt in dem Messsignal für die Auswerteeinrichtung zu verringern.

Bei einer besonders bevorzugten Ausführungsform der Erfindung ist die Signalquelle als eine steuerbare Konstantstromquelle ausgebildet, welche in Abhängigkeit eines Steuerungssignals einen konstanten Strom auf die Versorgungs - und/oder Signalleitungen aufprägt. Eine beispielhafte Realisierung der Signalquelle ist durch eine Konstantstromquelle gegeben, welche durch eine Mehrzahl von zuschaltbaren Widerständen in der Stromhöhe steuerbar ist. Diese konstruktive Ausführungsform weist den Vorteil einer sehr günstigen Umsetzung auf.

Bei einer vorteilhaften Realisierung ist die Auswerteeinrichtung ausgebildet, um eine Referenzsystemantwort mit einer Betriebssystemantwort zu vergleichen. Dieser Ausgestaltung liegt die Überlegung zu Grunde, dass das Meldesystem bzw. die Versorgungs- und/oder Signalleitungen in einem Idealzustand durch die Überwachungsvorrichtung getestet werden und die Systemantwort als Referenzsystemantwort abgespeichert wird. Bei einer späteren Überprüfung wird eine Systemantwort im laufenden Betrieb als Betriebssystemantwort ermittelt und die Referenzsystemantwort und die Betriebssystemantwort miteinander verglichen. Fallen die beiden Systemantworten zu weit auseinander, so wird auf einen unzulässigen Zustand des Meldesystems bzw. der Versorgungs- und/oder Signalleitungen geschlossen und das Überwachungssignal ausgegeben.

Bei einer weiteren Ausführungsform der Erfindung ist die Signalquelle als eine Stromsenke ausgebildet. Bevorzugt ist hierbei weiter vorgesehen, dass die Auswerteeinrichtung derart ausgebildet ist, dass die Auswerteeinrichtung den Leitungswiderstandes der Versorgungs- und/oder Signalleitungen ermittelt. Ferner ist vorgesehen, dass die Auswerteeinrichtung zum Vergleich des ermittelten Leitungswiderstandes mit einem vorgegebenen Leitungswiderstand ausgebildet ist.

Die Erfindung betrifft auch ein Meldesystem, insbesondere ein Brandschutz - und/oder Gefahrenmeldesystem, welches Versorgungs- und/oder Signalleitungen, eine Mehrzahl von Signaleingabe- und/oder Ausgabeeinrichtungen und eine Energieversorgungseinrichtung zur Versorgung der Mehrzahl von Signaleingabe - und/oder -ausgabeeinrichtungen aufweist, wobei die Mehrzahl von Signaleingabe- und/oder -ausgabeeinrichtungen in einer Parallelschaltung angeordnet sind. Die Energieversorgungseinrichtung ist insbesondere als eine Kleinspannungsversorgungseinrichtung mit einer Betriebsspannungen, insbesondere einer Gleichspannung, von kleiner 100 Volt, vorzugsweise kleiner 80 Volt und insbesondere kleiner als 50 Volt ausgebildet.

Der Erfindung folgend wird vorgeschlagen, dass das Meldesystem eine Überwachungsvorrichtung wie sie zuvor beschrieben wurde bzw. nach einem der vorhergehenden Ansprüche umfasst.

Bei einer besonders bevorzugten Ausführungsform ist die Überwachungsvorrichtung parallel zu der Mehrzahl der zu überwachenden Signaleingabe- und/oder Ausgabeeinrichtungen verschaltet. Soweit die Energieversorgungseinrichtung eine Gleichspannungsquelle ist, wird die Überwachungsvorrichtung mit einer Eingangsschnittstelle an den Pluspol und mit einer andern Eingangsschnittstelle an den Minuspol angehängt.

Es ist weiterhin bevorzugt, dass die Überwachungsvorrichtung als Abschlusseinrichtung in den der Versorgungs- und/oder Signalleitungen angeordnet ist. Diese Ausführungsform betrifft die Überwachungsvorrichtung als ein End-Of-Line-Modul, welches schaltungstechnisch gegenüberliegend zu der Energieversorgungseinrichtung verschaltet ist. Anders ausgedrückt sind zwischen Energieversorgungseinrichtung und Überwachungsvorrichtung die zu überwachenden Versorgungs- und/oder Signalleitungen verlaufend angeordnet.

Die Erfindung betrifft weiterhin ein Verfahren mit den Merkmalen des Anspruchs 14. Bei dem erfindungsgemäßen Verfahren wird in einer Initialisierungsphase durch Aufprägung eines ersten Prüfsignals auf die Versorgungs- und/oder Signalleitungen eine Referenzsystemantwort der Versorgungs- und/oder Signalleitung gemessen und gespeichert. Während der Überwachung wird ein zweites Prüfsignal aufgeprägt, wobei eine Betriebssystemantwort gemessen wird. Durch einen Vergleich der Referenzsystemantwort oder einer davon abgeleiteten Größe und der aktuellen Betriebssystemantwort wird auf den Zustand der Versorgungs - und/oder Signalleitungen geschlossen. Bei Überschreitung einer vordefinierten Abweichung wird das Überwachungssignal ausgegeben. Vorzugsweise ist das Meldesystem oder die Überwachungsvorrichtung zur Durchführung des Verfahrens ausgebildet und/oder geeignet.

Ferner betrifft die Erfindung ein alternatives Verfahren mit den Merkmalen des Anspruchs 15. Gemäß diesem Verfahren wird während der Überwachung ein Prüfsignal auf die Versorgungs- und/oder Signalleitungen aufgeprägt. Dabei wird eine Betriebssystemantwort in Form einer Spannung gemessen. Aus der gemessenen Betriebssystemantwort wird der Leitungswiderstand der Versorgungs - und/oder Signalleitungen ermittelt. Anschließend wird durch Vergleich des ermittelten Leitungswiderstandes mit einem vorgegebenen Leitungswiderstand der Zustand der Versorgungs- und/oder Signalleitungen überwacht. Dieses Verfahren hat den Vorteil, dass während des Betriebs des Meldesystems der elektrische Widerstand einer Versorgungs- und/oder Signalleitung ermittelbar ist. Dies trägt dazu bei, dass negativ auswirkende Systemveränderungen in den Versorgungs- und/oder Signalleitungen rechtzeitig und zuverlässig erkannt werden können.

Bei einer besonders bevorzugten Ausführungsform ist das Prüfsignal als ein Prüfstrom und/oder die Systemantwort als ein Spannungsabfall ausgebildet. Beispielsweise ist es denkbar, dass zur Erzeugung der Referenzsystemantwort eine in Stufen schaltbare Konstantstromquelle einen Prüfstrom so lange erhöht bis ein bestimmter Spannungseinbruch als Referenzsystemantwort gemessen werden kann. Der dabei ermittelte Prüfstrom sowie der gemessene Spannungseinbruch werden für die spätere Überwachung abgespeichert. Bei der Überwachung wird der gespeicherte Prüfstrom in regelmäßigen Abständen auf die Versorgungs - und/oder Signalleitungen gegeben und jeweils der Spannungseinbruch gemessen. Im Fall einer Veränderung im Vergleich zu dem abgespeicherten Spannungseinbruch, zum Beispiel wenn der Spannungseinbruch größer wird, wird das Überwachungssignal ausgegeben. Der notwendige Überwachungsstrom liegt bevorzugt in einem Bereich zwischen 0 mA und 50 mA, wobei Änderungen bzw. Spannungseinbruch im Bereich von 300 mV bis 500 mV erwartet werden. Das beschriebene Verfahren dient insbesondere zur Prüfung der Leitungen auf eine schleichende Unterbrechung (Creeping-open).

Um zudem eine Prüfung auf einen schleichenden Kurzschluss (Creeping-short) zu ermöglichen, wird zwischen den einzelnen Überwachungsvorgängen die Betriebsspannung auf den Leitungen gemessen und mit einem Sollwert verglichen. Wird dieser Sollwert unterschritten, erfolgt ebenfalls die Ausgabe eines Überwachungssignals.

Bei einer möglichen Weiterbildung der Erfindung wird vorgeschlagen, ein Softwareprogramm zur Simulation des Meldesystems zu verwenden, um zum einen die Höhe eines geeigneten Prüfstroms und zum anderen eine Abschätzung für eine Systemantwort ermitteln zu können. Dieses Softwareprogramm kann auch als separates Produkt angeboten werden und ist dadurch gekennzeichnet, dass die Überwachungsvorrichtung zusammen mit dem Meldesystem simuliert und analysiert wird.

### Kurze Beschreibung der Zeichnungen

Weitere Merkmale, Vorteile und Wirkungen der Erfindung ergeben sich aus der nachfolgenden Beschreibung sowie den beigefügten Figuren eines bevorzugten Ausführungsbeispiels der Erfindung. Dabei zeigen:
- Figur 1: ein schematisches Schaltdiagramm eines Meldesystems;
- Figur 2: ein Blockdiagramm der Überwachungsvorrichtung in dem Meldesystem in der Figur 1 als schematische Blockdarstellung als ein erstes Ausführungsbeispiel der Erfindung,
- Figur 3: ein Blockdiagramm der Überwachungsvorrichtung in dem Meldesystem in der Figur 1 als schematische Blockdarstellung als ein zweites Ausführungsbeispiel der Erfindung.

### Ausführungsform(en) der Erfindung

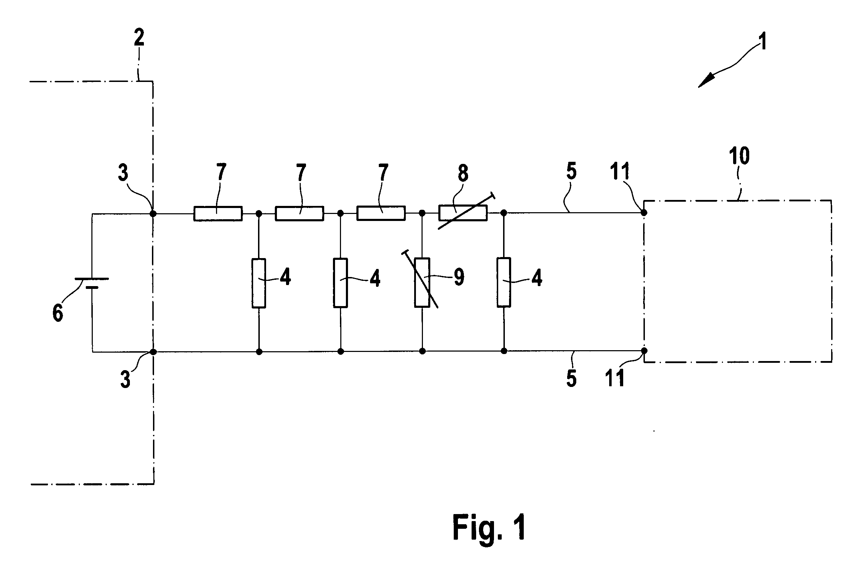

Die Figur 1 zeigt einen Abschnitt eines Brandmeldesystem 1 mit einer Überwachungszentrale 2, die signaltechnisch mit einer Mehrzahl von Signaleingabegeräten, wie zum Beispiel Feuermeldern, Notrufsäulen, etc. (nicht dargestellt), verbunden ist.

Die Überwachungszentrale 2 weist eine Schnittstelle 3 zur signaltechnischen Anbindung einer Mehrzahl von Signalisierungseinrichtungen 4 auf, welche beispielsweise als Sirenen, Hinweistafeln, Notbeleuchtungen, etc. ausgebildet sein können. Ausgehend von der Schnittstelle 3 sind die Signalisierungseinrichtungen 4 jeweils parallel zueinander angeordnet und mit Versorgungsleitungen 5 mit einer Energieversorgungseinrichtung 6 in der Überwachungszentrale 2 verbunden. Die Energieversorgungseinrichtung 6 ist als eine Gleichspannungsquelle im Kleinspannungsbereich von z.B. 30 V ausgebildet. Die Schnittstelle 3 dient in der gezeigten Anordnung in Figur 1 nur zur Energieversorgung der Signalisierungseinrichtungen 4, die Signalauslösung erfolgt durch (nicht-gezeigte) Signalleitungen.

Die Versorgungsleitungen 5 weisen zum einen reguläre Leitungswiderstände 7 auf, welche durch den Innenwiderstand oder Kontakte gebildet sind. Ergänzend ist in der Figur 1 ein Widerstand 8 gezeigt, welcher den Effekt des sogenannt Creeping-open bzw. der schleichenden Unterbrechung visualisieren soll. Creeping-open bezeichnet die langsame Erhöhung des Widerstands der Versorgungsleitungen 5 z. B. durch Oxidation von Kontakten etc. Obwohl der Widerstand 8 nur an einer Stelle eingezeichnet ist, kann sich der Widerstand der Versorgungsleitungen 5 an jeder beliebigen Stelle erhöhen. Weiterhin ist ein Kurzschlusswiderstand 9 dargestellt, welcher die Versorgungsleitungen 5 kurzschlussartig, insbesondere durch Überbrückung der Signalisierungseinrichtungen 4 verbindet. Ein derartiger Kurzschlusswiderstand 9 kann z.B. durch aufgescheuerte Versorgungsleitungen 5 entstehen. Auch der Kurzschlusswiderstand 9 kann an jeder beliebigen Stelle auftreten. Sowohl der Widerstand 8 als auch der Kurzschlusswiderstand 9 führen zu einer Funktionseinschränkung oder - unfähigkeit des Meldesystems 1, so dass es wünschenswert ist, die Entstehung dieser Widerstände 8, 9 möglichst frühzeitig zu detektieren.

Hierzu zeigt das Meldesystem 1 eine Überwachungsvorrichtung 10, welche über Anschlüsse 11 schaltungstechnisch parallel zu den Signalisierungseinrichtungen 4, und zwar an dem der Energieversorgungseinrichtung 6 gegenüberliegenden oder abgewandten Seite der Versorgungsleitungen 5 angeordnet ist, so dass zwischen der Überwachungsvorrichtung 10 und der Energieversorgungseinrichtung 6 die Signalisierungseinrichtungen 4 verschaltet sind. Es ist die Aufgabe der Überwachungsvorrichtung 10 die Entstehung des Widerstands 8 bzw. des Kurzschlusswiderstands 9 frühzeitig zu detektieren und der Überwachungszentrale 2 mittels eines Überwachungssignals mitzuteilen.

Hierzu wird bei der Inbetriebnahme des Brandmeldesystems 1 die Versorgungsleitung 5 zu den Signalisierungseinrichtungen 4 automatisch eingemessen. Dies geschieht beispielsweise, indem ein Prüfstrom von der Überwachungsvorrichtung 10 auf die Versorgungsleitungen 5 gegeben und solange erhöht wird, bis in den Versorgungsleitungen 5 ein bestimmter Spannungseinbruch gemessen werden kann. Der dabei ermittelte Wert des Prüfstroms bzw. des gemessenen Spannungseinbruchs wird für nachfolgende Überwachungsmessungen abgespeichert. Bei der späteren Überwachung wird z. B. in regelmäßigen Abständen Prüfstrom in gleicher Höhe wie der gespeicherte Wert auf die Versorgungsleitungen 5 gegeben und im Fall einer Veränderung des Spannungseinbruchs gegenüber dem abgespeicherten Wert die Ausgabe des Hinweissignals veranlasst. Durch dieses Vorgehen wird insbesondere die Entstehung des Widerstands 8, also die schleichende Unterbrechung, detektiert. Zur Überwachung eines schleichenden Kurzschlusses wird zwischen den Überwachungsmessungen die aktuelle Betriebsspannung auf den Versorgungsleitungen 5 mit einem vorgegebenen Sollwert verglichen. Wird dieser Sollwert unterschritten, erfolgt ebenfalls die Ausgabe eines Hinweissignals von der Überwachungsvorrichtung 10 an die Überwachungszentrale 2.

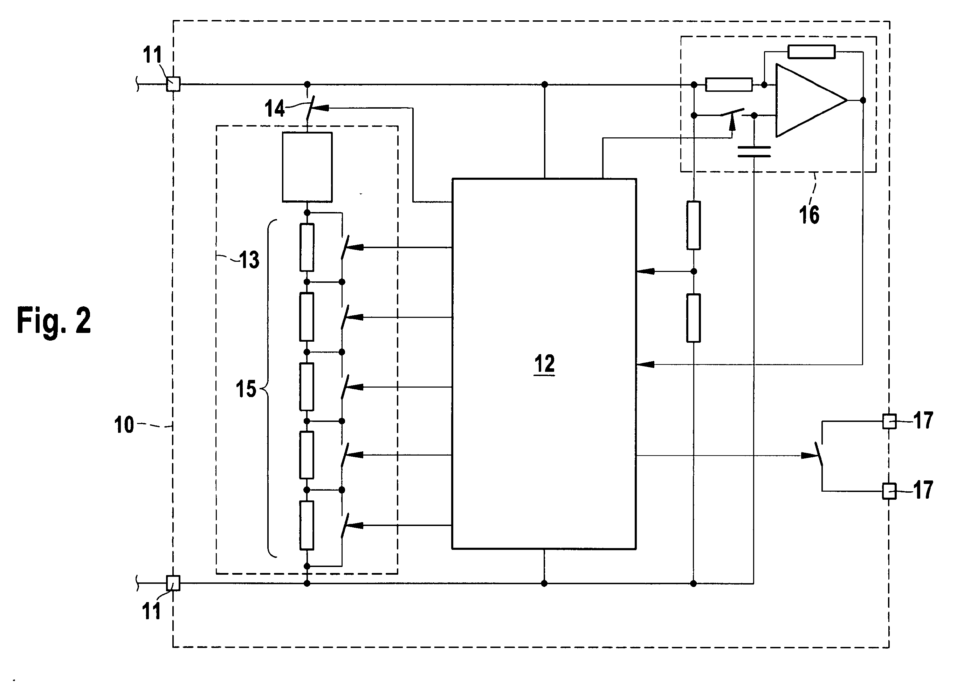

Die Figur 2 zeigt ein schematisches Blockdiagramm der Überwachungsvorrichtung 10 in Figur 1 als ein erstes Ausführungsbeispiel. Auf der linken Seite sind die Anschlüsse 11 zur Verbindung mit den Versorgungsleitungen 5 dargestellt. Die Überwachungsvorrichtung 10 umfasst einen Mikrocontroller 12, welche zur Steuerung der Überwachungsvorrichtung 10 ausgebildet ist.

In Parallelschaltung zu den Signalisierungsvorrichtungen 4 ist an den Anschlüssen 11 eine Konstantstromquelle 13 angeordnet, welche über einen Schalter 14 durch den Mikrocontroller 12 selektiv zuschaltbar ist Die Höhe des Konstantstroms wird durch eine Mehrzahl von ebenfalls durch den Mikrocontroller 12 zuschaltbaren Widerständen 15 eingestellt. Insgesamt dient die Konstantstromquelle 13 zur kontrollierten Einstellung des Prüfstroms in geeigneter Höhe.

Zur Messung einer Reaktion des Versorgungsleitungen 5 auf den eingeleiteten Prüfstrom, insbesondere zur Messung der Systemantwort in Form eines Spannungsabfalls durch Beaufschlagung der Versorgungsleitungen 5 mit dem Prüfstrom durch die Konstantstromquelle 13 weist die Überwachungsvorrichtung 10 eine sogenannte Sample-And-Hold-Vorrichtung 16 auf, welche die auftretende Spannungsdifferenz vor und nach der Beaufschlagung der Versorgungsleitungen 5 mit dem Prüfstrom misst.

Zur Ausgabe des Überwachungssignals zeigt die Überwachungsvorrichtung 10 eine Signalisierungsschnittstelle 17, welche das Hinweissignal beispielsweise an die Überwachungszentrale 2 zurückliefert.

Bei der Überwachung wird von dem Mikrokontroller 12 die Konstantstromquelle 13 über die Widerstände 15 in der Stromhöhe eingestellt und der Prüfstrom über den Schalter 14 auf die Versorgungsleitungen 5 gegeben. Der daraus resultierende Spannungsabfall in den Versorgungsleitungen 5 wird über die Sample-And-Hold-Vorrichtung 16 gemessen und an den Mikrokontroller 12 weitergegeben. Dieser vergleicht den Spannungsabfall mit einem zuvor gemessenen Referenzwert. Bei einer typischen Konstellation wird ein Prüfstrom von 10 mA bis 50 mA aufgeprägt, welcher (bei intakten Versorgungsleitungen 5) zu einem Spannungseinbruch von 30 mV bis 500 mV führt. Für den Fall, dass der Spannungsabfall deutlich stärker als der Referenzwert ausgebildet ist, wird auf einen unzulässigen Widerstand 8 geschlossen und das Hinweissignal über die Signalisierungsschnittstelle ausgegeben.

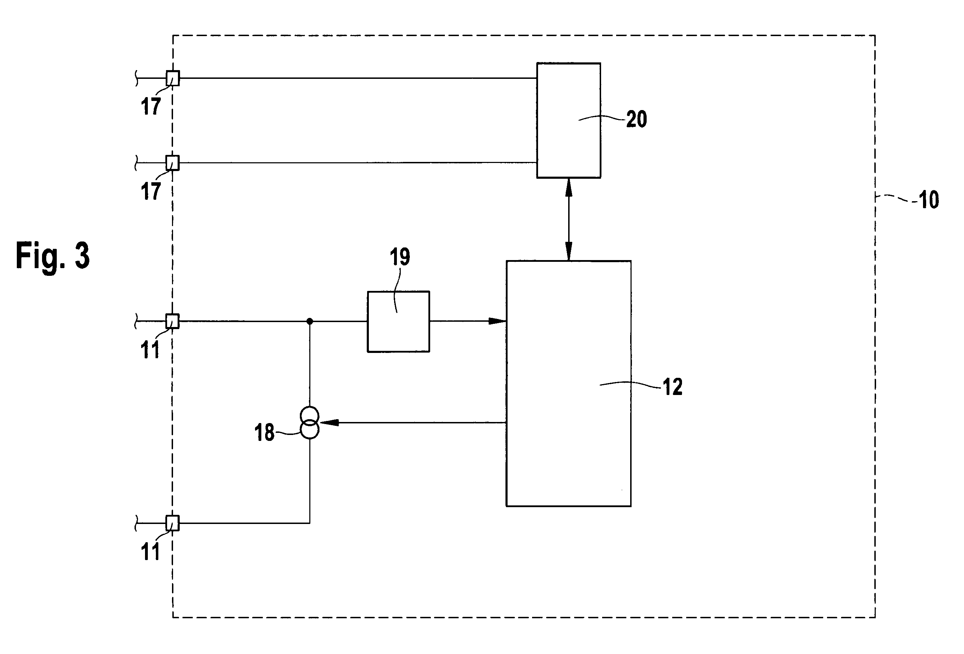

Die Figur 3 zeigt ein schematisches Blockdiagramm der Überwachungsvorrichtung 10 in Figur 1 als ein zweites Ausführungsbeispiel. Auf der linken Seite sind die Anschlüsse 11 zur Verbindung mit den Versorgungsleitungen 5 dargestellt. Die Überwachungsvorrichtung 10 umfasst einen Mikrocontroller 12, welche zur Steuerung der Überwachungsvorrichtung 10 ausgebildet ist.

In Parallelschaltung zu den Signalisierungsvorrichtungen 4 ist an den Anschlüssen 11 eine Stromsenke 18 angeordnet, wobei der Strom der Stromsenke 18 durch den Mikrocontroller 12 einstellbar ist. Insgesamt dient die Stromsenke 18 zur kontrollierten Einstellung des Prüfstroms in geeigneter Höhe.

Zur Messung einer Reaktion der Versorgungsleitungen 5 auf den eingeprägten Prüfstrom, insbesondere zur Messung der Systemantwort in Form eines Spannungsabfalls durch Beaufschlagung der Versorgungsleitungen 5 mit dem Prüfstrom durch die Stromsenke 18, weist die Überwachungsvorrichtung 10 eine Spannungsmesseinrichtung 19 auf, welche zur Messung der Spannung zwischen den Anschlüssen 11 ausgebildet ist

Zur Ausgabe des Überwachungssignals weist die Überwachungsvorrichtung 10 eine Kommunikationseinrichtung 20 auf, wobei die Kommunikationseinrichtung 20 dazu ausgebildet ist, über die Signalisierungsschnittstelle 17 das Hinweissignal über die Signalleitungen an die Überwachungszentrale 2 zurückzuliefern.

Gemäß dem zweiten Ausführungsbeispiel der Erfindung steuert der Mikrocontroller 12 die Überwachungseinrichtung 10 in einem ersten Schritt derart, dass mittels der Spannungsmesseinrichtung 19 die Spannung U₀ an den Anschlüssen 11, also am Ende der Versorgungsleitung 5, gemessen wird ohne dass die Versorgungsleitung 5 mit einem Prüfstrom beaufschlagt ist. Der Mikrocontroller 12 speichert die gemessene Spannung U₀. In einem zweiten Schritt steuert der Mikrocontroller 12 die Stromsenke 18 derart, dass der Versorgungsleitung 5 ein vorbestimmter Prüfstrom I aufgeprägt wird. Der vorbestimmte Prüfstrom I ist derart gewählt, dass ein signifikanter Spannungseinbruch aufgrund des Leitungswiderstandes R der Versorgungsleitung 5 auftritt. Während der Beaufschlagung der Versorgungsleitung 5 mit dem vorbestimmten Prüfstrom I steuert der Mikrocontroller 12 die Überwachungseinrichtung 10 derart, dass die Spannungsmesseinrichtung 19 die Spannung U₁ an den Anschlüssen 11, also am Ende der Versorgungsleitung 5, misst. Im dritten Schritt ermittelt der Mikrocontroller 12 daraus den Leitungswiderstand R.

Nach Ermittlung des Leitungswiderstandes R vergleicht der Mikrocontroller 12 den ermittelten Leitungswidertand R mit einem vorgegebenen maximalen Leitungswiderstand Rₘₐₓ. Falls der ermittelte Leitungswiderstand R größer ist als der vorgegebene maximale Leitungswiderstand Rₘₐₓ übermittelt der Mikrocontroller 12 über die Kommunikationseinrichtung 20 und die Signalleitungen eine Störungsmeldung als Überwachungssignal an die Überwachungszentrale 2. In der Überwachungszentrale 2 wird die Störungsmeldung zur Anzeige gebracht. Die Belastung der Versorgungsleitung 5 mit dem Prüfstrom I und die Ermittlung des Leitungswiderstandes R erfolgt in periodischen Abständen. Im zweiten Ausführungsbeispiel wird der vorgegebene maximale Leitungswiderstand Rₘₐₓ in der Überwachungszentrale 2 eingegeben und über die Signalleitungen und die Kommunikationseinrichtung 20 an den Mikrocontroller 12 der Überwachungsvorrichtung 10 übertragen. Alternativ oder zusätzlich kann der vorgegebene maximale Leitungswiderstand Rₘₐₓ direkt in der Überwachungsvorrichtung 10 eingegeben werden.

Sowohl im ersten Ausführungsbeispiel als auch im zweiten Ausführungsbeispiel kann als steuerbare Signalquelle zur Einkopplung eines Prüfsignals in Form eines Prüfstromes entweder eine Konstantstromquelle oder eine Stromsenke verwendet werden.

Optional ergänzend wird mit der Überwachungsvorrichtung 10 gemäß den beiden Ausführungsbeispielen auch ein Test hinsichtlich des Kurzschlusswiderstands 9 durchgeführt, indem ohne Beaufschlagung mit einem Prüfstrom die aktuelle Betriebsspannung der Energieversorgungseinrichtung 6 in der Überwachungsvorrichtung 10 gemessen und mit einem Sollwert verglichen wird. Wird der Sollwert unterschritten, so erfolgt ebenfalls die Ausgabe eines oder des Hinweissignals.

## Patentansprüche

1. Überwachungsvorrichtung (10) zur Überwachung des Betriebszustands von Versorgungs- und/oder Signalleitungen (5) eines Meldesystems (1), insbesondere eines Brandschutz- und/oder Gefahrenmeldesystems,
mit einer Messeinrichtung (16, 19), welche zur Erzeugung eines Messsignals in Abhängigkeit des Betriebszustands in den Versorgungs- und/oder Signalleitungen (5) ausgebildet, verschaltet und/oder verschaltbar ist,
und mit einer Auswerteeinrichtung (12), welche ausgebildet ist, das Messsignal auszuwerten und auf Basis der Auswertung ein Überwachungssignal auszugeben,
**gekennzeichnet durch**
eine steuerbare Signalquelle (13, 18), welche zur Einkopplung eines Prüfsignals in die Versorgungs- und/oder Signalleitungen (5) ausgebildet, verschaltet und/oder verschaltbar ist, wobei das Messsignal die Systemantwort der Versorgungs- und/oder Signalleitungen (5) auf das Prüfsignal umfasst.

2. Überwachungsvorrichtung (10) nach Anspruch 1, **dadurch gekennzeichnet, dass** das Prüfsignal als ein Gleichspannungs- und/oder Wechselspannungssignal bzw. ein Gleichstrom- und/oder Wechselstromsignal ausgebildet ist.

3. Überwachungsvorrichtung (10) nach Anspruch 1 oder 2, **dadurch gekennzeichnet, dass** die Auswerteeinrichtung zur Auswertung der Systemantwort der Versorgungs- und/oder Signalleitungen (5) in dem Messsignal auf einen Gleichspannungsanteil in dem Prüfsignal ausgebildet ist.

4. Überwachungsvorrichtung (10) nach einem der vorhergehenden Ansprüche, **dadurch gekennzeichnet, dass** die Signalquelle als eine steuerbare Konstantstromquelle (13) ausgebildet ist.

5. Überwachungsvorrichtung (10) nach Anspruch 4, **dadurch gekennzeichnet, dass** die Konstantstromquelle (13) durch eine Mehrzahl von zuschaltbaren Widerständen (15) steuerbar ist.

6. Überwachungsvorrichtung (10) nach einem der vorhergehenden Ansprüche, **dadurch gekennzeichnet, dass** die Auswerteeinrichtung (12) zum Vergleich einer Referenzsystemantwort mit einer Betriebssystemantwort ausgebildet ist.

7. Überwachungsvorrichtung (10) nach einem der Ansprüche 1 bis 3, **dadurch gekennzeichnet, dass** die Signalquelle als eine Stromsenke (18) ausgebildet ist.

8. Überwachungsvorrichtung (10) nach einem der Ansprüche 1 bis 3 oder 7, **dadurch gekennzeichnet, dass** die Auswerteeinrichtung (12) zur Ermittlung des Leitungswiderstandes der Versorgungs- und/oder Signalleitungen (5) ausgebildet ist.

9. Überwachungsvorrichtung (10) nach Anspruch 8, **dadurch gekennzeichnet, dass** die Auswerteeinrichtung (12) zum Vergleich des ermittelten Leitungswiderstandes mit einem vorgegebenen Leitungswiderstand ausgebildet ist.

10. Meldesystems (1), insbesondere Brandschutz- und/oder Gefahrenmeldesystem,
mit Versorgungs- und/oder Signalleitungen (5),
mit einer Mehrzahl von Signaleingabe- und/oder -ausgabeeinrichtungen (4) und
mit einer Energieversorgungseinrichtung (6) zur Versorgung der Mehrzahl von Signaleingabe- und/oder -ausgabeeinrichtungen (4), wobei die Mehrzahl von Signaleingabe- und/oder -ausgabeeinrichtungen (4) in Parallelschaltung angeordnet sind,
**gekennzeichnet durch**
eine Überwachungsvorrichtung (10) nach einem der vorhergehenden Ansprüche.

11. Meldesystem (1) nach Anspruch 10, **dadurch gekennzeichnet, dass** die Überwachungsvorrichtung (10) parallel zu der Mehrzahl von Signaleingabe - und/oder -ausgabeeinrichtungen (4) verschaltet ist.

12. Meldesystem (1) nach Anspruch 10 oder 11, **dadurch gekennzeichnet, dass** die Überwachungsvorrichtung (10) als Abschlusseinrichtung der Versorgungs- und/oder Signalleitungen (5) angeordnet ist.

13. Meldesystem (1) oder Überwachungsvorrichtung (10) nach einem der vorhergehenden Ansprüche, **dadurch gekennzeichnet, dass** die Überwachungsvorrichtung (10) zur Durchführung des Verfahrens der nachfolgenden Ansprüche ausgebildet ist.

14. Verfahren zur Überwachung von Versorgungs- und/oder Signalleitungen (5) eines Meldesystems (1), insbesondere nach einem der vorhergehenden Ansprüche 10 bis 13, **dadurch gekennzeichnet, dass** in einer Initialisierungsphase durch Aufprägen eines ersten Prüfsignals auf die Versorgungs - und/oder Signalleitungen (5) eine Referenzsystemantwort der Versorgungs - und/oder Signalleitungen (5) gemessen und gespeichert wird und während der Überwachung ein zweites Prüfsignal aufgeprägt wird, wobei eine Betriebssystemantwort gemessen wird, wobei durch Vergleich von Referenzsystemantwort und Betriebssystemantwort der Zustand der Versorgungs - und/oder Signalleitungen (5) überwacht wird.

15. Verfahren zur Überwachung von Versorgungs- und/oder Signalleitungen (5) eines Meldesystems (1), insbesondere nach einem der vorhergehenden Ansprüche 10 bis 13, **dadurch gekennzeichnet, dass** während der Überwachung ein Prüfsignal auf die Versorgungs- und/oder Signalleitungen (5) aufgeprägt wird, wobei eine Betriebssystemantwort gemessen wird und daraus der Leitungswiderstand der Versorgungs- und/oder Signalleitungen (5) ermittelt wird, wobei durch Vergleich des ermittelten Leitungswiderstandes mit einem vorgegebenen Leitungswiderstand der Zustand der Versorgungs - und/oder Signalleitungen (5) überwacht wird.

16. Verfahren nach einem der Ansprüche 14 oder 15, **dadurch gekennzeichnet, dass** das Prüfsignal als ein Prüfstrom und/oder die Referenzsystemantwort bzw. die Betriebssystemantwort als ein Spannungsabfall ausgebildet ist bzw. sind.

## Claims

1. Monitoring apparatus (10) for monitoring the operating condition of supply and/or signal lines (5) in an alarm system (1), particularly a fire prevention and/or hazard alarm system,
having a measuring device (16, 19) which is designed, interconnected and/or interconnectable for the purpose of producing a measurement signal on the basis of the operating condition in the supply and/or signal lines (5),
and having an evaluation device (12) which is designed to evaluate the measurement signal and to take the evaluation as a basis for outputting a monitoring signal,
**characterized by**
a controllable signal source (13, 18) which is designed, interconnected and/or interconnectable for the purpose of coupling a check signal into the supply and/or signal lines (5), wherein the measurement signal comprises the system response of the supply and/or signal lines (5) to the check signal.

2. Monitoring apparatus (10) according to Claim 1, **characterized in that** the check signal is in the form of a DC-voltage and/or AC-voltage signal or a DC and/or AC signal.

3. Monitoring apparatus (10) according to Claim 1 or 2, **characterized in that** the evaluation device is designed to evaluate the system response of the supply and/or signal lines (5) in the measurement signal to a DC-voltage component in the check signal.

4. Monitoring apparatus (10) according to one of the preceding claims, **characterized in that** the signal source is in the form of a controllable constant current source (13).

5. Monitoring apparatus (10) according to Claim 4, **characterized in that** the constant current source (13) can be controlled by a plurality of connectable resistors (15).

6. Monitoring apparatus (10) according to one of the preceding claims, **characterized in that** the evaluation device (12) is designed to compare a reference system response with an operating system response.

7. Monitoring apparatus (10) according to one of Claims 1 to 3, **characterized in that** the signal source is in the form of a current sink (18).

8. Monitoring apparatus (10) according to one of Claims 1 to 3 or 7, **characterized in that** the evaluation device (12) is designed to ascertain the line resistance of the supply and/or signal lines (5).

9. Monitoring apparatus (10) according to Claim 8, **characterized in that** the evaluation device (12) is designed to compare the ascertained line resistance with a prescribed line resistance.

10. Alarm system (1), particularly a fire prevention and/or hazard alarm system,
having supply and/or signal lines (5),
having a plurality of signal input and/or output devices (4), and
having a power supply device (6) for supplying power to the plurality of signal input and/or output devices (4), wherein the plurality of signal input and/or output devices (4) are arranged in a parallel circuit,
**characterized by**
a monitoring apparatus (10) according to one of the preceding claims.

11. Alarm system (1) according to Claim 10, **characterized in that** the monitoring apparatus (10) is interconnected in parallel with the plurality of signal input and/or output devices (4).

12. Alarm system (1) according to Claim 10 or 11, **characterized in that** the monitoring apparatus (10) is arranged as a terminating device for the supply and/or signal lines (5).

13. Alarm system (1) or monitoring apparatus (10) according to one of the preceding claims, **characterized in that** the monitoring apparatus (10) is designed to carry out the method of the subsequent claims.

14. Method for monitoring supply and/or signal lines (5) in an alarm system (1), particularly according to one of the preceding Claims 10 to 13, **characterized in that** in an initialization phase a first check signal is impressed onto the supply and/or signal lines (5) in order to measure and store a reference system response from the supply and/or signal lines (5) and during the monitoring a second check signal is impressed, wherein an operating system response is measured, with comparison of the reference system response and the operating system response monitoring the condition of the supply and/or signal lines (5).

15. Method for monitoring supply and/or signal lines (5) in an alarm system (1), particularly according to one of the preceding Claims 10 to 13, **characterized in that** during the monitoring a check signal is impressed onto the supply and/or signal lines (5), wherein an operating system response is measured and this is used to ascertain the line resistance of the supply and/or signal lines (5), with comparison of the ascertained line resistance with a prescribed line resistance monitoring the condition of the supply and/or signal lines (5).

16. Method according to either of Claims 14 and 15, **characterized in that** the check signal is in the form of a check current and/or the reference system response and/or the operating system response is/are in the form of a voltage drop.

## Revendications

1. Ensemble de surveillance (10) destiné à surveiller l'état de fonctionnement de conducteurs d'alimentation et/ou de signalisation (5) d'un système d'alarme (1), notamment d'un système d'alarme incendie et/ou d'alarme danger, l'ensemble comprenant :
un dispositif de mesure (16, 19) qui est configuré, raccordé ou peut être raccordé pour former un signal de mesure qui est fonction de l'état de fonctionnement des conducteurs d'alimentation et/ou de signalisation (5) et
un dispositif d'évaluation (12) configuré pour évaluer le signal de mesure et délivrer un signal de surveillance sur la base de l'évaluation,
**caractérisé par**
une source asservie (13, 18) de signaux qui est configurée, raccordée ou peut être raccordée pour injecter un signal de vérification dans les conducteurs d'alimentation et/ou de signalisation (5), le signal de mesure comportant la réponse du système de conducteurs d'alimentation et/ou de signalisation (5) au signal de vérification.

2. Ensemble de surveillance (10) selon la revendication 1, **caractérisé en ce que** le signal de vérification est configuré comme signal en tension continue et/ou en tension alternative ou un signal en courant continu et/ou en courant alternatif.

3. Ensemble de surveillance (10) selon les revendications 1 ou 2, **caractérisé en ce que** pour évaluer la présence d'une partie en tension continue dans le signal de vérification, le dispositif d'évaluation est configuré pour évaluer la réponse du système de conducteurs d'alimentation et/ou de signalisation (5) dans le signal de mesure.

4. Ensemble de surveillance (10) selon l'une des revendications précédentes, **caractérisé en ce que** la source de signaux est configurée comme source asservie (13) de courant constant.

5. Ensemble de surveillance (10) selon la revendication 4, **caractérisé en ce que** la source (13) de courant constant peut être commandée par plusieurs résistances (15) commutables.

6. Ensemble de surveillance (10) selon l'une des revendications précédentes, **caractérisé en ce que** le dispositif d'évaluation (12) est configuré pour comparer une réponse de référence du système à une réponse de fonctionnement du système.

7. Ensemble de surveillance (10) selon l'une des revendications 1 à 3, **caractérisé en ce que** la source de signaux est configurée comme drain (18) de courant.

8. Ensemble de surveillance (10) selon l'une des revendications 1 à 3 ou 7, **caractérisé en ce que** le dispositif d'évaluation (12) est configuré pour déterminer la résistance des conducteurs d'alimentation et/ou de signalisation (5).

9. Ensemble de surveillance (10) selon la revendication 8, **caractérisé en ce que** le dispositif d'évaluation (12) est configuré pour comparer à une résistance prédéterminée la résistance des conducteurs qui a été déterminée.

10. Système d'alarme (1), notamment système d'alarme incendie et/ou d'alarme danger, le système comprenant :
des conducteurs d'alimentation et/ou de signalisation (5),
plusieurs dispositifs (4) d'entrée et/ou de sortie de signaux, et
un dispositif (6) d'alimentation en énergie qui alimente les différents dispositifs (4) d'entrée et/ou de sortie de signaux, les différents dispositifs (4) d'entrée et/ou de sortie de signaux étant raccordés en parallèle,
**caractérisé par**
un ensemble de surveillance (10) selon l'une des revendications précédentes.

11. Système d'alarme (1) selon la revendication 10, **caractérisé en ce que** l'ensemble de surveillance (10) est raccordé en parallèle par rapport aux différents dispositifs (4) d'entrée et/ou de sortie de signaux.

12. Système d'alarme (1) selon les revendications 10 ou 11, **caractérisé en ce que** l'ensemble de surveillance (10) est disposé comme dispositif de commutation des conducteurs d'alimentation et/ou de signalisation (5).

13. Système d'alarme (1) ou ensemble de surveillance (10) selon l'une des revendications précédentes, **caractérisés en ce que** l'ensemble de surveillance (10) est configuré pour mettre en oeuvre le procédé selon les revendications qui suivent.

14. Procédé de surveillance de conducteurs d'alimentation et/ou de signalisation (5) d'un système d'alarme (1), notamment d'un système d'alarme selon l'une des revendications 10 à 13 qui précèdent, **caractérisé en ce que**
dans une phase d'initialisation, une réponse de référence du système de conducteurs d'alimentation et/ou de signalisation (5) est mesurée en appliquant un signal de vérification sur les conducteurs d'alimentation et/ou de signalisation (5) et est conservée en mémoire,
**en ce qu'**un deuxième signal de vérification est appliqué pendant la surveillance,
**en ce que** la réponse du système en fonctionnement est mesurée et
**en ce que** l'état des conducteurs d'alimentation et/ou de signalisation (5) est surveillé par comparaison entre la réponse de référence du système et la réponse du système en fonctionnement.

15. Procédé de surveillance de conducteurs d'alimentation et/ou de signalisation (5) d'un système d'alarme (1), notamment d'un système d'alarme selon l'une des revendications 10 à 13 qui précèdent, **caractérisé en ce que**
dans une phase d'initialisation, une réponse du système de conducteurs d'alimentation et/ou de signalisation (5) en fonctionnement est mesurée et la résistance des conducteurs d'alimentation et/ou de signalisation (5) en est déterminée et
**en ce que** l'état des conducteurs d'alimentation et/ou de signalisation (5) est surveillé par comparaison entre la résistance des conducteurs qui a été déterminée et une résistance prédéterminée des conducteurs.

16. Procédé selon l'une des revendications 14 ou 15, **caractérisé en ce que** le signal de vérification est configuré comme courant de vérification et/ou **en ce que** la réponse de référence du système ou la réponse du système en fonctionnement sont configurées comme chute de tension.
